# EUROPÄISCHE PATENTANMELDUNG

(11) **EP 2 482 333 A1**
(43) Veröffentlichungstag der Anmeldung: **01.08.2012**
(21) Anmeldenummer: 11000736.6
(22) Anmeldetag: 31.01.2011
(51) Int. Cl.: H01L 31/048, H01L 31/052

(54) **Solarzellenempfänger**

(71) Anmelder: AZURSPACE Solar Power GmbH, 74072 Heilbronn (DE)
(72) Erfinder: Schilling, Roland, 75050 Gemmingen (DE); Khorenko, Victor, 74196 Neuenstadt a. K. (DE)
(74) Vertreter: Koch Müller Patentanwaltsgesellschaft mbH

(57) **Zusammenfassung**

Solarzellenempfänger mit einem Halbleiterkörper, aufweisend eine Vorderseite mit einer auf der Vorderseite ausgebildeten Solarzelle und eine Rückseite und mehrere Seitenfläche und zwei elektrischen Anschlüssen, und einem Träger zur Aufnahme des Halbleiterkörpers, wobei die Rückseite des Halblelterkörpers auf dem Träger fixiert ist, und einem Optisches Element für eine Bündelung von Licht auf die Vorderseite des Halbleiterkörpers, aufweisend eine Unterseite, die der Oberseite des Halbleiterkörpers teilweise zugewandt ist, wobei der Optisches Element an der Unterseite eine erste Ausformung mit einer ersten Oberfläche aufweist, die auf der Vorderseite des Halbleiterkörpers aufliegt und eine zweite Oberfläche aufweist, die auf dem Träger aufliegt und die Ausformung als Kavität oder als Falz ausgebildet ist.

## Beschreibung

Die Erfindung betrifft ein Solarzellenempfänger gemäß dem Oberbegriff des Patentanspruchs 1.

Aus der EP 2 073 279 A1 ist ein Solarzellenempfänger bekannt, bei dem ein als Solarzelle ausgebildeter Halbleiterkörper auf einem Träger angeordnet ist. Um den Halbleiterkörper und insbesondere dessen Seitenflächen vor Umgebungselnflüssen zu schützen, die zu einer Degradation der elektrischen Parameter führen, wird um den Halbleiterkörper an drei Seiten ein Rahmen angeordnet und mit einem transparenten Deckel abgeschlossen. Anschließend wird der verbleibende Zwischenraum mit einer transparenten Vergussmasse aufgefüllt und ein optisches Element angebracht.

Aus der EP 1 953 825 A2 ist ein Gehäuse bekannt, bei dem auf einem Träger ein als LED ausgebildeter Halbleiterkörper angeordnet ist. Anschließend wird zum Schutz des Halbleiterkörpers eine Dichtfolie und ein aus mehreren Teilen bestehendes Gehäuse, welches auch ein optisches Element umfasst, in einem mehrstufigen Prozess auf dem Träger angeordnet.

Vor diesem Hintergrund besteht die Aufgabe der Erfindung darin, eine Vorrichtung anzugeben, die den Stand der Technik weiterbildet.

Die Aufgabe wird durch ein Solarzellenempfänger mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Solarzellenempfänger mit einem Halbleiterkörper offenbart, aufweisend eine Vorderseite mit einer auf der Vorderseite ausgebildeten Solarzelle und eine Rückseite und mehrere Seitenflächen und zwei elektrischen Anschlüssen, und einem Träger zur Aufnahme des Halbleiterkörpers, wobei die Rückseite des Halbleiterkörpers auf dem Träger fixiert ist, und einem optischen Element für eine Bündelung von Licht auf die Vorderseite des Halbleiterkörpers, aufweisend eine Unterseite, die der Oberseite des Halbleiterkörpers teilweise zugewandt ist, wobei das optische Element an der Unterseite eine erste Ausformung mit einer ersten Oberfläche aufweist, die auf der Vorderseite des Halbleiterkörpers aufliegt und eine zweite Oberfläche aufweist, die auf dem Träger aufliegt und die Ausformung als Kavität oder als Falz ausgebildet ist.

Ein Vorteil der erfindungsgemäßen Vorrichtung ist es, dass das optische Element, welches vorzugsweise als Konzentrator ausgebildet ist, eine der Form und Größe des Halbleiterkörpers angepasste Ausformung aufweist und durch Absenken des optischen Elements auf den Träger den als Solarzelle ausgebildeten Halbleiterkörper und insbesondere die Seitenränder des Halbleiterkörpers zuverlässig vor Umgebungseinflüssen schützt. Indem das optische Element zugleich auch Gehäuse ist, wird eine kostengünstige Lösung geschaffen, äußerst robuste Solarzellenempfänger herzustellen. Die Anzahl der Fertigungsschritte zur Herstellung des Solarzellenmoduls wird reduziert.

Untersuchungen der Anmelder haben gezeigt, dass sich unterschiedliche Formen von optischen Elementen als Gehäuse ausbilden lassen, welche die aus dem Träger herausstehenden Teile des Halbleiterkörpers allseitig umschließen. Hierbei ist es bevorzugt, die jeweiligen Formen des optischen Elements einstückig auszubilden. Bevorzugte Formen von optischen Elementen sind unter anderem eine linsenförmige oder trichterförmige oder pyramidenstumpfförmige Ausbildung. Gemeinsames Kennzeichen der unterschiedlichen Formen von den optischen Elementen ist es, dass jede Form an der Unterseite eine umlaufende Randfläche aufweist, welche im Wesentlichen formschlüssig mit der Oberfläche des Trägers abschließt. Es ist bevorzugt, dass die Kavität oder der Falz der ersten Ausformung des optischen Elements vollständig umlaufend um die Seitenflächen des Halbleiterkörpers ausgebildet sind. Bei der Ausführung mit einem Falz an der Unterseite des optischen Elements ist auf der Vorderseite des Halbleiterkörpers nur der äußere Randbereich mit einem Teil des Falzes des optischen Elements abgedeckt. Es ist bevorzugt in dem äußeren Randbereich des Halbleiterkörpers, der von dem Falz bedeckt wird, eine Dichtschicht, die vorzugsweise als transparente Klebstoffschicht ausgebildet ist, zwischen dem optischen Element und der Vorderseite des Halblelterkörpers anzuordnen.

In einer Weiterbildung bildet die erste Ausformung zusammen mit den Seitenflächen des Halbleiterkörpers ein Zwischenraum aus. Es ist bevorzugt, den Zwischenraum mit einer transparenten Vergussmasse aufzufüllen. In einer alternativen Ausführungsform ist zwischen den Seitenflächen und der ersten Ausformung ein Dichtmittel vorgesehen. Bevorzugt lässt sich die Vergussmasse als transparentes Dichtmittel ausführen.

In einer anderen Ausführungsform ist es bevorzugt, zwischen der zweiten Oberfläche und dem Träger eine Klebstoffschicht, die vorzugsweise als transparente Schicht ausgebildet ist, angeordnet. Hierdurch lässt sich das optische Element fixieren. Des Weiteren bildet die Klebstoffschicht eine Dichtfläche zwischen dem optischen Element und Träger aus, so dass der Halbleiterkörper hermetisch gegenüber der Umgebung abgedichtet ist. In einer anderen Weiterbildung wird zusätzlich oder alternativ zwischen der ersten Oberfläche und der Vorderseite des Halbleiterkörpers eine Vergussmasse, die vorzugsweise als transparente Vergussmasse ausgebildet ist, angeordnet.

Gemäß einer Weiterbildung weist das optische Element eine zweite als Kavität ausgebildete Ausformung auf. Es ist bevorzugt, dass das optische Element in der zweiten Ausformung einen aus der Oberfläche des Trägers ausgebildeten Teil einer By-Pass-Diode aufnimmt. Hierbei ist die By-Pass-Diode beabstandet von dem Halbleiterkörper. In einer alternativen Ausführungsform ist es bevorzugt, dass die zweite Ausformung mit der ersten Ausformung eine Verbindung aufweist, derart dass nur eine einzige Ausformung ausgebildet wird, welche beide Bauteile aufnimmt. Hierdurch bildet sich nach dem Aufbringen des optischen Elements zwischen wenigstens einer Seitenfläche der Solarzelle und wenigstens einer Seitenfläche der By-Pass-Diode ein gemeinsamer Zwischenraum, der bevorzugt mit einer Vergussmasse aufgefüllt wird.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine schematischen Querschnitt auf eine erfindungsgemäße Ausführungsform eines Solarzellenempfängers mit einem optischen Element,
- Figur 2: einen schematischen Querschnitt auf ein Solarzellenempfänger mit einem optischen Element und einer By-PassDiode,
- Figur 3: einen schematischen Querschnitt auf ein Solarzellenempfänger mit einem pyramidenförmigen optischen Element mit einer By-Pass-Diode,
- Figur 4: einen schematischen Querschnitt auf ein Solarzellenempfänger mit einem trichterförmigen optischen Element mit einer By-Pass-Diode.

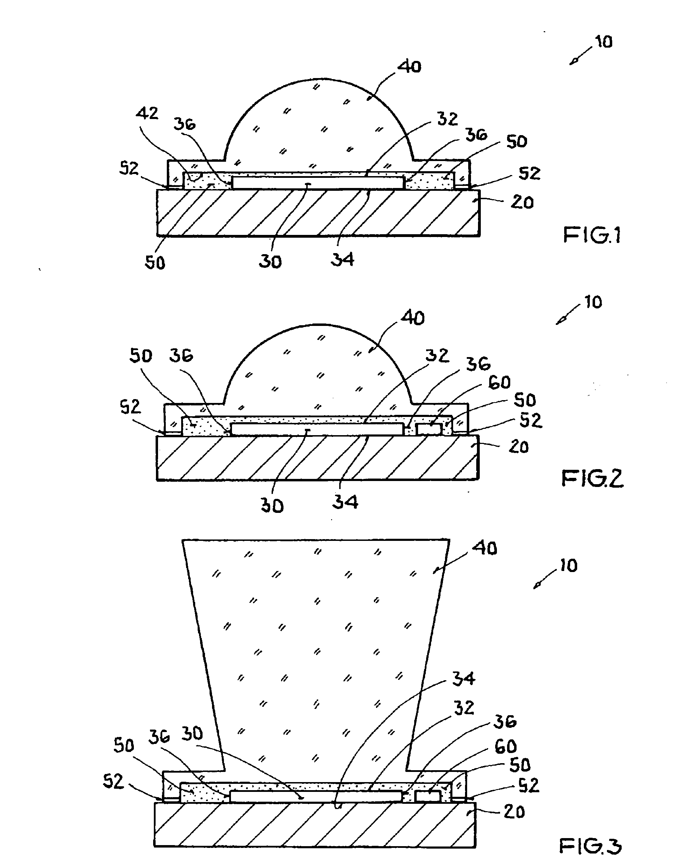

Die Abbildung der Figur 1 zeigt einen schematischen Querschnitt eines erfindungsgemäßen Solarzellenempfängers 10, aufweisend einen Träger 20, einen als Solarzelle ausgebildeten Halbleiterkörper 30 mit einer Vorderseite 32 und einer Rückseite 34 und mehreren Seitenfläche 36. Die Rückseite 34 des Halbleiterkörpers 30 ist auf dem Träger 20 fixiert. Oberhalb der Vorderseite 32 ist ein linsenförmiges optisches Element 40 ausgebildet, der eine Unterseite mit einer Kavität 42 zur Aufnahme des Halbleiterkörpers 30 ausbildet. Eine erste Oberfläche des optischen Elements 40 ist oberhalb der Vorderseite 32 des Halbleiterkörpers 30 ausgebildet. Das optische Element 40 liegt mit einer zweiten Oberfläche auf dem Träger 20 auf. Die Kavität 42 ist größer ausgebildet als der Halbleiterkörper 30. Der Raum zwischen dem optischen Element 40 und dem Halbleiterkörper 30 ist mit einer vorzugswelsen transparenten Vergussmasse 50 ausgefüllt. Ferner ist zwischen der zweiten Oberfläche und dem Träger 20 eine Klebstoffschicht 52 ausgebildet. Des Weiteren weist der Halbleiterkörper 30 wenigstens zwei elektrische Anschlüsse vorzugsweise auf der Vorderseite auf, welche nicht dargestellt sind. Es sei angemerkt, dass das optische Element 40 vorzugsweise einstückig ausgeführt ist und neben der Funktion der Bündelung von einfallendem Licht auf die Vorderseite des Halbleiterkörpers 30, eine dichtende Eigenschaft insbesondere in Zusammenhang mit der Vergussmasse 50 und der Klebstoffschicht 52 aufweist, d.h. den Halbleiterkörper 30 vor Umgebungsweinflüssen schützt. Die Bündelung von Licht wird mittels der linsenförmigen Ausbildung des optischen Elements 40 erzielt.

In der Abbildung der Figur 2 ist eine weitere Ausführungsform des Solarzellenempfängers 10 dargestellt. Nachfolgend werden nur die Unterschiede zu der Ausführungsform der Figur 1 erläutert. Auf dem Träger 20 ist eine By-Pass-Diode 60 beabstandet angeordnet. Die By-Pass-Diode 60 ist mit der Solarzelle verschaltet - nicht dargestellt. Die Größe der Kavität 42 umfasst die By-Pass-Diode 60.

Der Raum zwischen dem optischen Element 40 und der By-Pass-Diode 60 ist mit der Vergussmasse 50 ausgefüllt. Hierdurch ist die By-Pass-Diode 60 sowohl durch das optische Element 40 als auch von der Vergussmasse 50 in Verbindung mit der Klebstoffschicht 52 vor Umgebungseinflüssen geschützt.

In der Figur 3 ist ein schematischer Querschnitt eines Solarzellenempfängers dargestellt, bei dem das optische Element 40 eine pyramidenstumpfförmige Ausbildung aufweist. Die Kavität 42 an der Unterseite umfasst sowohl die Solarzelle als auch die By-Pass-Dlode 60. Das auf das optische Element 40 einfallenden Licht wird vorzugsweise auf dem Wege der Totalreflektion auf die Vorderseite 32 des Halbleiterkörpers 30 geleitet.

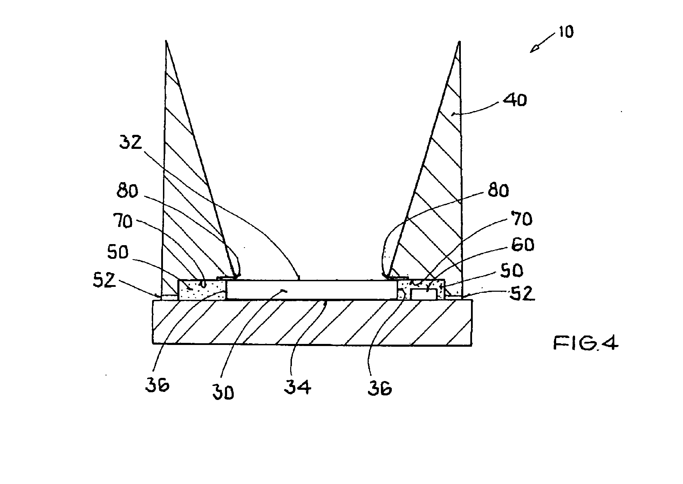

In der Figur 4 ist in einem schematischen Querschnitt eine trichterförmige Ausbildung des optischen Elements 40 dargestellt. An der Innenseite des Trichters wird das einfallende Licht auf dem Wege der spiegelnden Reflektion zur Vorderseite des Halbleiterkörpers 30 geleitet. Hierfür lässt sich die Innenseite des Trichters mit einer reflektierenden metallischen Schicht bedecken. An der Unterseite des optischen Elements 40 ist ein umlaufender Falz 70 ausgeformt. Die Vorderseite 32 des Halbleiterkörpers 30 ist im Bereich der Trichteröffnung weder von dem optischen Element 40 noch von der Vergussmasse 50 bedeckt. Demhingegen ist die Vorderseite 32 des Halbleiterkörpers 30 im Bereich des Randes von dem Falz 70 bedeckt. Vorzugsweise ist zwischen dem auf der Vorderseite 32 aufliegenden Teil des Falzes 70 und dem Halbleiterkörper 30 eine Dichtschicht 80 ausbildet. Der verbleibende Raum des Falzes 70 ist mit der Vergussmasse 50 ausgefüllt.

## Patentansprüche

1. Solarzellenempfänger (10) mit,
- einem Halblelterkörper (30), aufweisend eine Vorderseite (32) mit einer auf der Vorderseite ausgebildeten Solarzelle und eine Rückseite (34) und mehrere Seitenfläche (36) und zwei elektrischen Anschlüssen,
- einem Träger (20) zur Aufnahme des Halbleiterkörpers, wobei die Rückseite (34) des Halbleiterkörpers (30) auf dem Träger (20) fixiert ist,
- einem optischen Element (40) für eine Bündelung von Licht auf die Vorderseite (32) des Halbleiterkörpers (30), aufweisend eine Unterseite, die der Oberseite des Halbleiterkörpers (30) teilweise zugewandt ist,
**dadurch gekennzeichnet, dass**
das optische Element (40) an der Unterseite eine erste Ausformung mit einer ersten Oberfläche aufweist, die auf der Vorderseite des Halblelterkörpers (30) aufliegt und eine zweite Oberfläche aufweist, die auf dem Träger (20) aufliegt und die Ausformung als Kavität (42) oder als Falz (70) ausgebildet ist.

2. Solarzellenempfänger (10) nach Anspruch 1, **dadurch gekennzeichnet, dass** die erste Ausformung und die Seitenflächen (36) des Halbleiterkörpers (30) ein Zwischenraum ausbilden.

3. Solarzellenempfänger (10) nach Anspruch 1 oder 2, **dadurch gekennzeichnet, dass** zwischen den Seitenflächen (36) und der ersten Ausformung ein Dichtmittel vorgesehen ist.

4. Solarzellenempfänger (10) nach einem der Ansprüche 1 bis 3, **dadurch gekennzeichnet, dass** zwischen der zweiten Oberfläche und dem Träger (20) eine Klebstoffschicht (52) ausgebildet ist.

5. Solarzellenempfänger (10) nach einem der Ansprüche 1 bis 4, **dadurch gekennzeichnet, dass** zwischen der ersten Oberfläche und der Vorderseite (32) des Halbleiterkörpers (30) eine Vergussmasse (50) ausgebildet ist.

6. Solarzellenempfänger (10) nach einem der Ansprüche 1 bis 5, **dadurch gekennzeichnet, dass** die Kavität (42) oder der Falz (70) der ersten Ausformung vollständig umlaufend um die Seitenflächen (36) des Halbleiterkörpers (30) ausgebildet sind.

7. Solarzellenempfänger (10) nach einem der Ansprüche 1 bis 6, **dadurch gekennzeichnet, dass** das optische Element (40) eine zweite als Kavität ausgebildete Ausformung aufweist.

8. Solarzellenempfänger (10) nach dem Anspruch 7, **dadurch gekennzeichnet, dass** das optische Element (40) eine zweite Ausformung mit einer Kavität aufweist und die Kavität der zweiten Ausformung den auf den Träger (20) ausgebildeten Teil einer By-Pass-Diode (60) aufnimmt.

9. Solarzellenempfänger (10) nach dem Anspruch 8, **dadurch gekennzeichnet, dass** die Kavität (42) den Halbleiterkörper (30) und die By-Pass-Diode (60) aufnimmt.

10. Solarzellenempfänger (10) nach einem der Ansprüche 1 bis 9, **dadurch gekennzeichnet, dass** das optische Element (40) linsenförmig ausgebildet ist.

11. Solarzellenempfänger (10) nach einem der Ansprüche 1 bis 10, **dadurch gekennzeichnet, dass** das optische Element (40) trichterförmig ausgebildet ist.

12. Solarzellenempfänger (10) nach einem der Ansprüche 1 bis 11, **dadurch gekennzeichnet, dass** das optische Element (40) pyramidenstumpfförmig ausgebildet ist.

13. Solarzellenempfänger (10) nach einem der Ansprüche 1 bis 12, **dadurch gekennzeichnet, dass** das optische Element (40) einstückig ausgebildet ist.

## Geänderte Patentansprüche

### Geänderte Patentansprüche gemäss Regel 137(2) EPÜ.

**1.** Solarzellenempfänger (10) mit,
- einem Halbleiterkörper (30), aufweisend eine Vorderseite (32) mit einer auf der Vorderseite ausgebildeten Solarzelle und eine Rückseite (34) und mehrere Seitenfläche (36) und zwei elektrischen Anschlüssen,
- einem Träger (20) zur Aufnahme des Halbleiterkörpers, wobei die Rückseite (34) des Halbleiterkörpers (30) auf dem Träger (20) fixiert ist,
- einem optischen Element (40) für eine Bündelung von Licht auf die Vorderseite (32) des Halbleiterkörpers (30), aufweisend eine Unterseite, die der Oberseite des Halbleiterkörpers (30) teilweise zugewandt ist, wobei das optische Element (40) an der Unterseite eine erste Ausformung mit einer ersten Oberfläche aufweist, die auf der Vorderseite des Halbleiterkörpers (30) aufliegt und das optische Element (40) eine zweite Oberfläche aufweist, die auf dem Träger (20) aufliegt und die erste Ausformung als Kavität (42) oder als Falz (70) ausgebildet ist,
**dadurch gekennzeichnet, dass**
der Träger (20) eine ebene Oberfläche aufweist und das optische Element (40) einstückig ausgebildet ist und mit dem Halbleiterkörper (30) auf der Oberfläche des Trägers (20) angeordnet ist, wobei die Kavität (42) oder der Falz (70) größer als der Halbleiterkörper (30) ist und der Raum zwischen der Kavität (42) des optischen Elements (40) und den Seitenflächen (36) des Halbleiterkörpers (30) und der Oberfläche des Trägers (20) mit einer Vergussmasse (50) ausgefüllt ist.

**2.** Solarzellenempfänger (10) nach Anspruch 1, **dadurch gekennzeichnet, dass** die By-Pass Diode (60) auf der ebenen Oberfläche des Trägers (20) in der Kavität (42) angeordnet ist.

**3.** Solarzellenempfänger (10) nach Anspruch 1 oder 2, **dadurch gekennzeichnet, dass** zwischen den Seitenflächen (36) und der ersten Ausformung ein Dichtmittel vorgesehen ist.

**4.** Solarzellenempfänger (10) nach einem der Ansprüche 1 bis 3, **dadurch gekennzeichnet, dass** zwischen der zweiten Oberfläche und dem Träger (20) eine Klebstoffschicht (52) ausgebildet ist.

**5.** Solarzellenempfänger (10) nach einem der Ansprüche 1 bis 4, **dadurch gekennzeichnet, dass** zwischen der ersten Oberfläche und der Vorderseite (32) des Halbleiterkörpers (30) eine Vergussmasse (50) ausgebildet ist.

**6.** Solarzellenempfänger (10) nach einem der Ansprüche 1 bis 5, **dadurch gekennzeichnet, dass** die Kavität (42) oder der Falz (70) der ersten Ausformung vollständig umlaufend um die Seitenflächen (36) des Halbleiterkörpers (30) ausgebildet sind.

**7.** Solarzellenempfänger (10) nach einem der Ansprüche 1 bis 6, **dadurch gekennzeichnet, dass** das optische Element (40) eine zweite als Kavität ausgebildete Ausformung aufweist.

**8.** Solarzellenempfänger (10) nach dem Anspruch 7, **dadurch gekennzeichnet, dass** die zweite Ausformung mit der ersten Ausformung derart eine Verbindung aufweist, dass nur einen einzige Ausformung ausgebildet wird.

**9.** Solarzellenempfänger (10) nach einem der Ansprüche 1 bis 8, **dadurch gekennzeichnet, dass** das optische Element (40) linsenförmig ausgeblldet ist.

**10.** Solarzellenempfänger (10) nach einem der Ansprüche 1 bis 9, **dadurch gekennzeichnet, dass** das optische Element (40) trichterförmig ausgebildet ist.

**11.** Solarzellenempfänger (10) nach einem der Ansprüche 1 bis 10, **dadurch gekennzeichnet, dass** das optische Element (40) pyramldenstumpfförmig ausgebildet Ist.

**12.** Solarzellenempfänger (10) nach einem der Ansprüche 1 bis 11, **dadurch gekennzeichnet, dass** die-Vergussmasse (50) transparent ist.
